# EUROPEAN PATENT APPLICATION

(11) **EP 4 475 181 A1**
(43) Date of publication of application: **11.12.2024**
(21) Application number: 24180918.5
(22) Date of filing: 07.06.2024
(51) Int. Cl.: H01L 23/473

(54) **COOLING SYSTEM FOR POWER ELECTRONICS**

(30) Priority: 09.06.2023 US 202363507223 P; 04.12.2023 US 202363605688 P
(71) Applicant: Carrier Corporation, Palm Beach Gardens, FL 33418 (US)
(72) Inventor: JOARDAR, Arindom, Syracuse, 13221 (US); BUSHNELL, Peter, Syracuse, 13221 (US)
(74) Representative: Dehns

(57) **Abstract**

A cooling system (60) for cooling at least one heat-generating electronic device (62) includes a heat removal device (74) having a surface (114) that is thermally couplable to the at least one heat-generating electronic device (62). The heat removal device (74) includes an inlet area (102) and at least one jet impingement feature (110) fluidly coupled to the inlet area (102). The at least one jet impingement feature (110) is positioned to direct a primary cooling fluid (C1) toward the surface (114) that is thermally coupled to the at least one heat-generating electronic device (62).

## Description

### BACKGROUND

Exemplary embodiments pertain to the art of heat exchangers, and more particularly to heat exchangers for cooling power electronics.

Power electronics devices such as motor drives generate waste heat during operation of the device. Additionally, when the power electronics devices heat up, the operational efficiency of the devices can degrade adding to the amount of heat generated. When utilized in a refrigeration system to drive, for example, a compressor of the refrigeration system, effective thermal integration of these devices can be important aspect to the system's overall efficiency and reliability. Consequently, a goal of the system integrator is to maintain these components within a range of operating temperatures which will maximize the system efficiency. Accordingly, there remains a need in the art for heat exchangers configured to closely integrate with power electronic devices which can maintain optimal temperatures for these components under a variety of load conditions.

### BRIEF DESCRIPTION

According to an embodiment, a cooling system for cooling at least one heat-generating electronic device includes a heat removal device having a surface that is thermally couplable to the at least one heat-generating electronic device. The heat removal device includes an inlet area and at least one jet impingement feature fluidly coupled to the inlet area. The at least one jet impingement feature is positioned to direct a primary cooling fluid toward the surface that is thermally coupled to the at least one heat-generating electronic device.

In addition to any one or more of the features described herein, in further embodiments the heat removal device includes a heat exchanger having an outlet header and the surface that is thermally coupled to the at least one heat-generating electronic device is arranged within the outlet header. The primary cooling fluid and a secondary cooling fluid are arranged in a heat transfer relationship within the at least one heat exchanger.

In addition to any one or more of the features described herein, in further embodiments the heat exchanger includes an inlet header and a plurality of heat exchange tubes extending between the inlet header and the outlet header. The at least one jet impingement feature is separate from and fluidly coupled to the plurality of heat exchange tubes.

In addition to any one or more of the features described herein, in further embodiments the heat exchanger further comprises an inlet header and a plurality of heat exchange tubes extending between the inlet header and the outlet header. The at least one jet impingement feature is integral with at least one of the plurality of heat exchange tubes.

In addition to any one or more of the features described herein, in further embodiments a fluid movement device is operable to move the secondary cooling fluid through the heat removal device.

In addition to any one or more of the features described herein, in further embodiments the fluid movement device is a fan and the secondary cooling fluid is air.

In addition to any one or more of the features described herein, in further embodiments the heat removal device includes a plurality of heat exchangers. Each of the plurality of heat exchangers is located at and is thermally coupled to a respective heat-generating electronic device.

In addition to any one or more of the features described herein, in further embodiments at least some of the plurality of heat exchangers are arranged in series relative to a flow of the primary cooling fluid.

In addition to any one or more of the features described herein, in further embodiments at least some of the plurality of heat exchangers are arranged in parallel relative to a flow of the primary cooling fluid.

In addition to any one or more of the features described herein, in further embodiments the primary cooling fluid provided to the inlet area is a two-phase liquid.

In addition to any one or more of the features described herein, in further embodiments the primary cooling fluid provided to the heat removal device is a single-phase liquid.

According to another embodiment, a method of cooling an assembly including at least one heat-generating electronic device and at least one peripheral heat-generating device includes cooling a secondary cooling fluid via a primary cooling fluid, flowing the cooled secondary cooling fluid over the at least one peripheral heat-generating device, and expelling the primary cooling fluid at a surface of a heat removal device thermally coupled to the at least one heat-generating electronic device via at least one jet impingement feature to cool the at least one heat-generating electronic device.

In addition to any one or more of the features described herein, in further embodiments the heat removal device is a heat exchanger and cooling the secondary cooling fluid via the primary cooling fluid occurs within a plurality of heat exchanger tubes of the heat exchanger.

In addition to any one or more of the features described herein, in further embodiments the method comprises providing the secondary cooling fluid to the heat exchanger via a fluid movement device.

In addition to any one or more of the features described herein, in further embodiments the method comprises providing the primary cooling fluid to another heat removal device located at and thermally coupled to the at least one heat-generating electronic device. The another heat removal device may be arranged downstream from and in series with the heat removal device relative to a flow of the primary cooling fluid.

In addition to any one or more of the features described herein, in further embodiments the method comprises providing the primary cooling fluid to another heat removal device located at and thermally coupled to the at least one heat-generating electronic device. The another heat removal device may be arranged in parallel with the heat removal device relative to a flow of the primary cooling fluid.

### BRIEF DESCRIPTION OF THE DRAWINGS

The following descriptions are provided by way of example only and should not be considered limiting in any way. With reference to the accompanying drawings, like elements are numbered alike:
FIG. 1 is a schematic diagram of an example of a refrigeration system;
FIG. 2 is a schematic diagram of another example of a heating, ventilation, air conditioning and refrigeration (HVAC&R) system;
FIG. 3 is an illustration of an embodiment of a cooling system for cooling a heat-generating device;
FIG. 4 is a cross-sectional view of a heat removal device of a cooling system;
FIG. 5 is a cross-sectional view of a heat removal device of a cooling system;
FIG. 6 is a perspective view of a prior art cooling system of a variable frequency drive.

### DETAILED DESCRIPTION

A detailed description of one or more embodiments of the disclosed apparatus and method are presented herein by way of exemplification and not limitation with reference to the Figures.

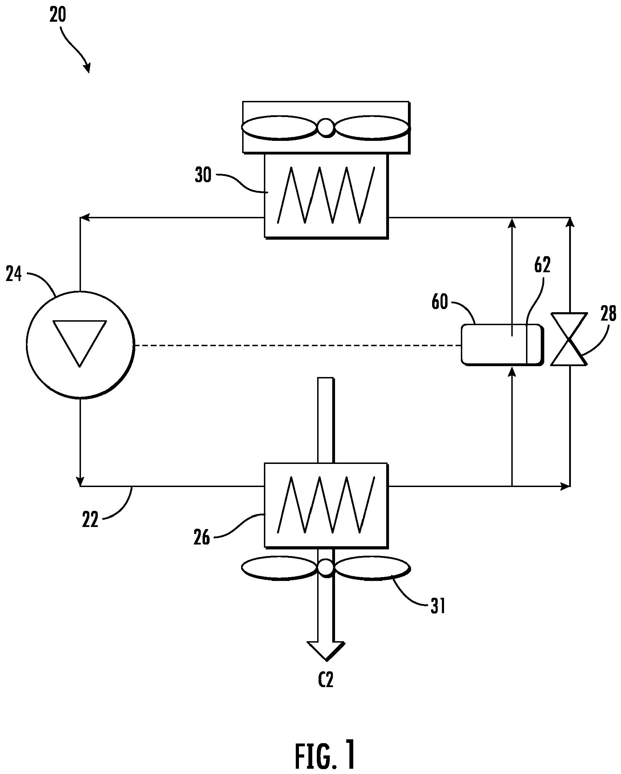

Referring to FIG. 1, an example of a refrigeration system, such as a heating, ventilation, air conditioning and refrigeration (HVAC&R) system 20 is schematically illustrated. Exemplary refrigeration systems 20 include, but are not limited to, residential, split, packaged, chiller, rooftop, supermarket, transport, and fuel cell systems, for example. In the illustrated, non-limiting embodiment, the refrigeration system 20 includes a refrigeration circuit 22 including a compressor 24, a condenser 26, an expansion device 28 and an evaporator 30 arranged in series and having a volume of refrigeration fluid, such as refrigerant for example, flowing therethrough.

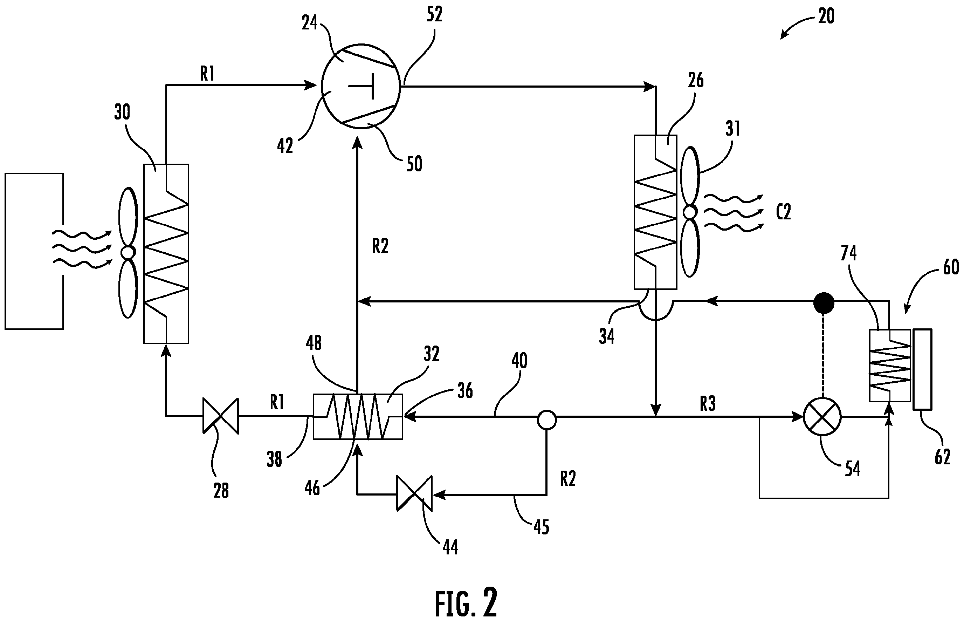

Another example of a refrigeration system 20 is illustrated in FIG. 2. In addition to the compressor 24, condenser 26, expansion device 28, and evaporator 30 previously described the refrigeration circuit 22 includes an economizer heat exchanger 32. The economizer heat exchanger 32 may be positioned between the condenser 26 and the expansion device 28 relative to a flow of refrigeration fluid through the refrigeration circuit 22. Although the economizer heat exchanger 32 is illustrated as being located directly downstream from the outlet 34 of the condenser 26, it should be understood that embodiments where one or more other components of the refrigeration system 20 are located between the condenser 26 and an inlet of the economizer heat exchanger 32 are also contemplated herein.

In an embodiment, the economizer heat exchanger 32 is a brazed plated fin heat exchanger. However, other suitable types of heat exchangers are also within the scope of the disclosure. Further, the economizer heat exchanger 32 is a refrigeration fluid-refrigeration fluid heat exchanger and therefore has a plurality of distinct fluid flow paths formed therein. In the illustrated, non-limiting embodiment, the economizer heat exchanger 32 has a first flow path and a second flow path, respectively.

In the illustrated, non-limiting embodiment, the inlet 36 of the first flow path of the economizer heat exchanger 32, also referred to herein as the "main flow path," is arranged in direct fluid communication with an outlet 34 of the condenser 26. Alternatively, or in addition, the outlet 38 of the main flow path of the economizer heat exchanger 32 may be arranged directly upstream from and in fluid communication with an inlet of the expansion device 28.

In operation, a first portion R1 of the refrigeration fluid output from the condenser 26 is provided to the main flow path of the economizer heat exchanger 32 via a main conduit 40. Although the main flow path is illustrated as a single pass through the economizer heat exchanger 32, it should be understood that in other embodiments the main flow path may include a plurality of passes through the economizer heat exchanger 32. At the outlet 38 of the main flow path of the economizer heat exchanger 32, the first portion R1 of the refrigeration fluid is configured to flow to the expansion device 28. From the expansion device 28, the refrigeration fluid is expanded within the evaporator 30. The first portion R1 of refrigeration fluid output from the evaporator 30 is provided via a first compressor inlet path to a primary suction inlet 42 of the compressor 24. Accordingly, the fluid loop of the first portion R1 of the refrigeration fluid includes the compressor 24, condenser 26, main flow path of the economizer heat exchanger 32, expansion device 28, and the evaporator 30.

An economizer expansion device 44 may be arranged within the refrigeration circuit 22 in fluid communication with the condenser 26. The economizer expansion device 44 is operable to expand and cool the refrigeration fluid provided thereto. Although the economizer expansion device 44 is illustrated as being disposed within an economizer conduit 45 fluidly coupled to an extending from the main conduit 40 at a location upstream from the first inlet 36, it should be understood that an economizer conduit 45 fluidly connected to the outlet 34 of the condenser 26 in another suitable manner is also contemplated herein.

Located downstream from the economizer expansion device 44 is the inlet 46 of a second flow path of the economizer heat exchanger 32, also referred to herein as the "economizer flow path." Further, the outlet 48 of the second flow path of the economizer heat exchanger 32 may but need not be directly connected to an economizer inlet or port 50 of the compressor 24. In the illustrated, non-limiting embodiment, the inlet 36 of the main flow path and the inlet 46 of the economizer flow path are arranged at adjacent sides of the economizer heat exchanger 32. However, in other embodiments, it should be understood that the inlets 36, 46 of both flow paths could alternatively be arranged at the same side of the economizer heat exchanger 32 or at opposite sides thereof. Similarly, the outlets 38, 48 of both the main flow path and the economizer flow path may be arranged at opposite sides, the same side, or adjacent sides depending on the desired flow configuration of the economizer heat exchanger 32. Further, although the economizer flow path is illustrated as a single pass, it should be understood that in some embodiments, the economizer flow path may include a plurality of passes through the economizer heat exchanger 32.

Within the economizer flow path, a second portion R2 of the refrigeration fluid is configured to absorb heat from the first portion R1 of the refrigeration fluid within the main flow path, thereby cooling the first portion R1 of the refrigeration fluid. As a result of this heat transfer, the second portion R2 of the refrigeration fluid within the economizer flow path may become a vapor. From the outlet 48 of the economizer flow path, the second portion R2 of the refrigeration fluid is provided to the economizer suction inlet 50 located at an intermediate portion of the compressor 24. Accordingly, the second portion R2 of the refrigeration fluid bypasses the expansion device 28 and the evaporator 30 of the refrigeration circuit 22. Within the compressor 24 the first portion R1 and the second portion R2 of refrigeration fluid are mixed before being provided to the discharge port 52 to repeat the cycle. Accordingly, the fluid loop of the second portion R2 of the refrigeration fluid includes the compressor 24, condenser 26, economizer expansion device 44, and economizer flow path of the economizer heat exchanger 32. It should be understood that the refrigeration systems 20 illustrated and described herein are intended as an example only, and that a refrigeration system 20 having another configuration is within the scope of the disclosure.

With continued reference to both FIGS. 1 and 2, in an embodiment, the refrigeration system 20 includes at least one cooling system 60 for cooling one or more heat-generating devices 62. The term "heat-generating device" as used herein can refer to any electronic component which generates heat during operation thereof. Examples of a heat-generating device 62 include, but are not limited to a processor, power electronic devices, or another device that can provide a controlled output power by modulating and/or converting a supplied input power (e.g., a variable frequency drive, power rectifier, power converter, and the like). Such a heat-generating device 62 can be used to control the speed of a compressor and/or the speed of a fan associated with of a refrigeration system based on various predetermined system conditions. In an embodiment, the at least one heat-generating device 62 includes a variable frequency drive operably coupled to the compressor 24 of the refrigeration system 20. As shown, at least a portion R3 of the refrigerant output from an outlet of the condenser 26 may be diverted towards the cooling system 60. Depending on the cooling demands to be met by the cooling system 60, the portion R3 of the refrigerant may pass through an expansion valve 54 or may bypass the expansion valve before reaching a heat removal device 74 of the cooling system 60, to be described in more detail below.

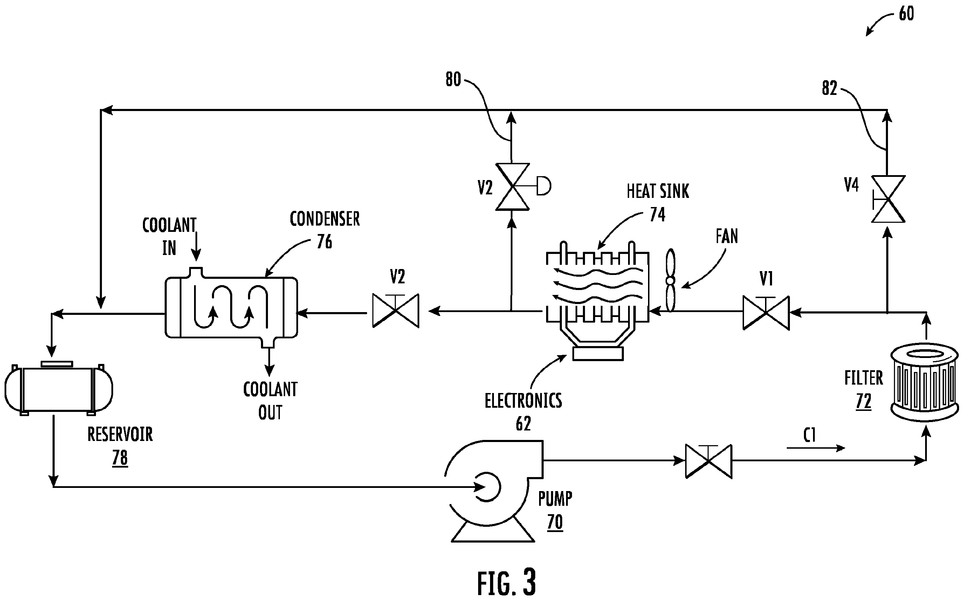

In other embodiments, the cooling system 60 need not be integral with or a part of the vapor compression cycle of a refrigeration system 20. Rather, the cooling system 60 may be a separate fluid loop and may use any suitable cooling fluid therein. In the illustrated, non-limiting embodiment of FIG. 3, the circuit of the cooling system 60 has a closed loop configuration and includes a pump 70 for moving a primary cooling fluid C1 therethrough. A filter 72 may be located upstream from at least one heat removal device 74 positioned to directly cool a corresponding heat-generating electronic device, such as heat-generating device 62. Downstream from the one or more heat removal devices 74 is a cooling heat exchanger 76 configured to remove heat from the primary cooling fluid C1. The circuit may additionally include a reservoir or accumulator 78 within which excess primary cooling fluid C1 is stored. As shown, the circuit may include a plurality of valves, such as arranged directly upstream from the heat removal device 74 (V1), directly downstream from the heat removal device 74 (V2), associated with a bypass conduit 80 for bypassing the cooling heat exchanger 76 (V3), and/or associated with another bypass conduit 82 for bypassing both the heat removal device 74 and the cooling heat exchanger 76 (V4). Although the illustrated non-limiting embodiment includes a single heat removal device 74 associated with a single heat-generating device 62, it should be appreciated that embodiments including a plurality of heat removal devices 74, operably coupled to one or more heat-generating devices 62, may be arranged in series or in parallel relative to the flow of the primary cooling fluid C 1.

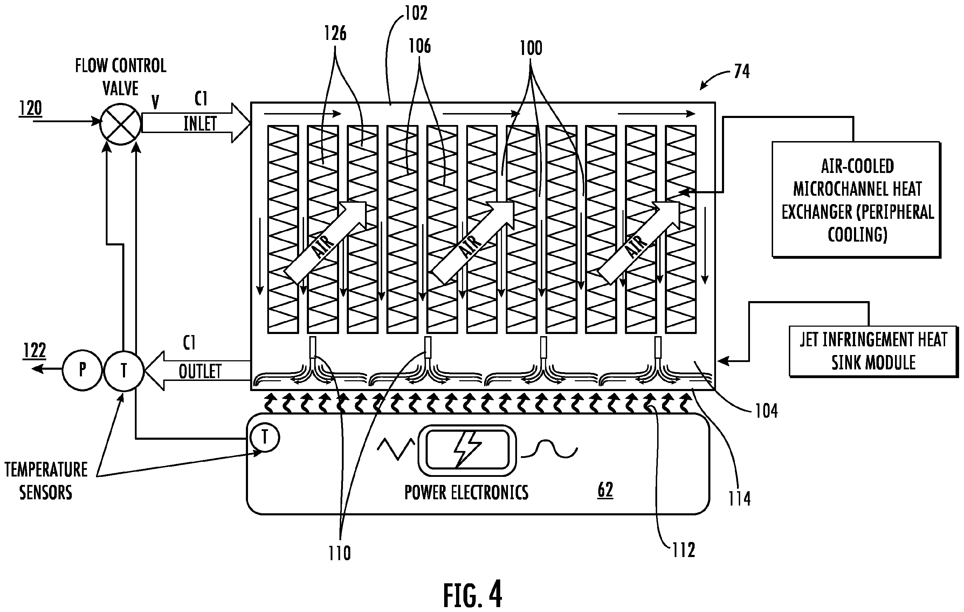

With reference now to FIG. 4, an example of at least a portion of a cooling system 60 for cooling one or more heat-generating devices 62 is illustrated. As shown in the FIG., the heat removal device 74 may be a heat exchanger, such as a microchannel heat exchanger having a plurality of substantially parallel microchannel heat exchanger tubes 100 extending between an inlet header 102 and an outlet header 104, each of the plurality of heat exchanger tubes 100 defining a plurality of fluid flow paths (not shown). However, examples of other types of heat exchangers that may be used, include, but are not limited to, microtube, double pipe, shell and tube, tube and fin, plate, plate and shell, adiabatic shell, plate fin, pillow plate, and fluid heat exchangers. The type of heat exchanger 74 selected may depend at least in part based on the type of fluids being provided thereto.

A primary cooling fluid C1 and a secondary cooling fluid C2 are arranged in a heat transfer relationship at the heat exchanger 74. In the non-limiting embodiment illustrated in FIG. 4, the heat exchanger 74 has a single pass configuration for both the primary cooling fluid C1 and the secondary cooling fluid C2. However, in other embodiments, at least one of the primary and secondary cooling fluids C1, C2 may make multiple passes through the heat exchanger 74. Further, the primary and secondary cooling fluids C1, C2 may be arranged in any suitable flow configuration at the heat exchanger, such as a cross-flow, a parallel flow, a counter-flow, or any combination thereof.

In an embodiment, at least one jet impingement feature, such as a nozzle, jet, or orifice, hole, or opening formed in a plate 110, and in some embodiments a plurality of jet impingement features 110 are arranged within the outlet header 104, such as within an inlet area of the outlet header 104. Each jet impingement features 110 is fluidly coupled to at least one fluid flow path of one or more heat exchanger tubes 100. An outlet end of the jet impingement features 110 may be aimed at a surface of the outlet header 104 thermally coupled to at least one selected heat-generating device 62, such as a bottom surface of the outlet header 104 for example. Although the one or more jet impingement features 110 are illustrated and described herein as being separate from the heat exchange tubes 100, in an embodiment, an outlet end of the heat exchange tubes 100 may be contoured such that one or more jet impingement features 110 are integral therewith. The jet impingement features 110 may be configured as a free surface type or submerged type or confined-submerged type. Furthermore, the jet or flow expelled from the jet impingement features 110 may be of any geometrical shape in the cross-section such as circular, polygonal, star-shaped etc.

In some embodiments, the heat exchanger 74 is directly coupled to a surface of the at least one selected heat-generating device 62. In such a direct connection, a thermal interface material may, but need not be arranged between a surface 112 of the at least one selected heat-generating electronic device 62 and an adjacent surface 114 of the heat removal device 74 to facilitate the transfer of heat from the at least one selected heat-generating device 62 to the heat removal device 74.

The inlet header 102 of the heat exchanger 74 may be fluidly connected to a first fluid inlet 120 and the outlet header 104 may be fluidly connected to a first fluid outlet 122 to form a first flow path of the primary cooling fluid C1. In operation, the primary cooling fluid C1, such as a refrigerant for example, is provided from the first fluid inlet 120 into the inlet header 102 of the heat exchanger 74. The primary cooling fluid C1 provided to the inlet header 102 may be a single phase, such as a cool or cold liquid for example, or may be two-phase (i.e., a combination of liquid and vapor). From the inlet header 102, the primary cooling fluid C1 flows through the plurality of heat exchange tubes 100 of the heat exchanger 74 toward the outlet header 104.

The secondary cooling fluid C2 is configured to flow through the gaps 106 defined between adjacent heat exchanger tubes 100. In the illustrated, non-limiting embodiment, the secondary cooling fluid C2 is a flow of air moved (in a direction extending into the plane of the page) by the at least one fluid movement device, such as fan 31. In an embodiment, the is associated with at least one of a condenser 26 or evaporator 30 of the refrigeration system 20. However, it should be understood that any fluid, including a liquid, may be used as the secondary cooling fluid C2. In the illustrated, non-limiting embodiment, a plurality of fins 126 is arranged within the gaps 106 defined between adjacent heat exchanger tubes 100; however, embodiments that do not include such fins are also contemplated herein. Within the plurality of passages of the heat exchange tubes 100, heat from the secondary cooling fluid C2 is transferred to the primary cooling fluid C1. The resulting cooled secondary cooling fluid C2 provided at an outlet of the heat exchanger 74 may be configured to flow over the neighboring or peripheral heat-generating devices, such as within the variable frequency drive for example.

At least a portion of the now slightly warmer primary cooling fluid C1 is output from the plurality of heat exchange tubes 100 to the one or more jet impingement features 110 arranged within the outlet header 104. Within the jet impingement features 110, the flow rate of the primary cooling fluid C1 is increased such that the primary cooling fluid C1 is expelled from an outlet of the jet impingement features at a surface of the outlet header 104 vertically aligned with the selected heat-generating device 62.

At least a portion of the heat from the at least one selected heat-generating device 62 is transferred from the heat-generating device 62 to the primary cooling fluid C1. The continuous impingement of the primary cooling fluid C1 on the surface of the outlet header 104 thermally coupled to the heat-generating device 62 transfers heat from the surface of the outlet header 104 to the primary cooling fluid C1, thereby cooling the at least one selected heat-generating device 62.

Depending on the temperature of the secondary cooling fluid C2, the primary cooling fluid C1 may partially evaporate or may remain in a liquid state as it flows through the plurality of heat exchange tubes 100 of the heat exchanger 74 toward the outlet header 104. If the primary cooling fluid C1 is partially evaporated, the velocity of the primary cooling fluid C1 expelled from the one or more jet impingement features 110, which will enhance the heat transfer that occurs from the surface of the outlet header 104 to the primary cooling fluid C1. In an embodiment, after impinging on the surface 114, the primary cooling fluid C1 is configured to start boiling or evaporating, and in some embodiments, is in a completely vapor state. After contacting the surface of the outlet header 104, the resulting warm, superheated vaporprimary cooling fluid C1 then exits the outlet header 104 of the heat exchanger 74 and flows toward the first fluid outlet 122.

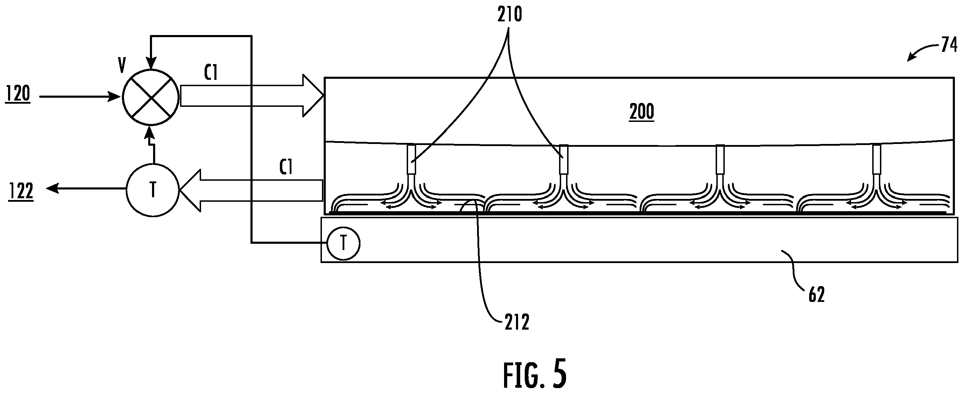

With reference now to FIG. 5, another example of a heat removal device 74 suitable for use in a cooling system 60 is illustrated. The heat removal device 74 may be similar to that described above with respect to FIG. 4. However, in the illustrated, non-limiting embodiment, the heat removal device does not include the heat exchanger portion for receiving the secondary cooling fluid C2. As shown, the heat removal device 74 includes an inlet area 200 and at least one jet impingement feature 210, and in some embodiments a plurality of jet impingement features 210, fluidly coupled to the inlet area 200. Similar to the heat exchanger previously described herein, the outlet end of the jet impingement features 210 is aimed at a surface of the heat removal device 74 thermally coupled to at least one selected heat-generating electronic device 62, such as a bottom surface 202 of the heat removal device 74 for example.

In each of the configurations disclosed in FIGS. 4 and 5, at least one valve may be arranged within the first fluid inlet 120 and/or the first fluid outlet 122 to control the flow of the primary cooling fluid C1 to and from the heat exchanger 74. In an embodiment, the position of the one or more flow control valve(s) V and therefore the flow through the heat exchanger 74, is actively managed based on a one or more conditions, for example indicative of the thermal load, at the heat exchanger 74. The thermal load may be determined using information collected by one or more sensors, represented schematically at T and P. In the illustrated, non-limiting embodiment, a first sensor T is operable to monitor the temperature of the heat-generating device 62, and a second sensor T is operable to monitor the temperature of the primary cooling fluid C1 in conjunction with a pressure sensor P at the outlet header 104. The combination of a temperature sensor and a pressure sensor will allow determination of a degree of superheat of the exiting primary cooling fluid C1. The flow control valve V can be adjustable to increase or decrease the flow rate based on the degree of superheat of the primary cooling fluid C1 determined. The at least one sensor T or P may be operable to measure temperature and/or pressure directly or may be configured to monitor another parameter that correlates to or can be used to derive temperature and/or pressure therefrom.

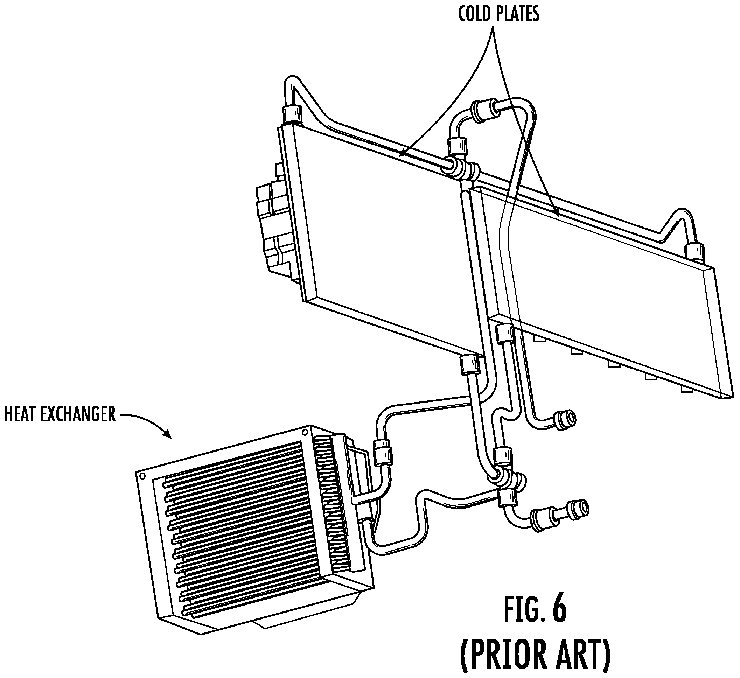

FIG. 6 illustrates and existing cooling system for cooling one or more heat-generating component of the variable frequency drive (VFD). As shown, the cooling system includes two cold plates to which the heat-generating device(s) 62 that require the most cooling are mounted. In addition, an air-cooled heat exchanger is used to cool peripheral components, such as those that are not mounted to the cold plates. If the heat removal device 74 is integrated into the cooling system of the VFD, the separate air-cooled heat exchanger can be eliminated because the heat exchangers will be mounted directly to the heat-generating components that are also mounted to the cold plates. Such a combination results in a more compact, low cost and efficient cooling system. Elimination of the separate air-cooled heat exchanger results in significant cost savings.

The term "about" is intended to include the degree of error associated with measurement of the particular quantity based upon the equipment available at the time of filing the application.

The terminology used herein is for the purpose of describing particular embodiments only. As used herein, the singular forms "a," "an" and "the" are intended to include the plural forms as well, unless the context clearly indicates otherwise. It will be further understood that the terms "comprises" and/or "comprising," when used in this specification, specify the presence of stated features, integers, steps, operations, elements, and/or components, but do not preclude the presence or addition of one or more other features, integers, steps, operations, element components, and/or groups thereof.

While the present invention has been described with reference to an exemplary embodiment or embodiments, it will be understood by those skilled in the art that various changes may be made and equivalents may be substituted for elements of the embodiments without departing from the scope of the present invention, which is defined by the claims. In addition, many modifications may be made to adapt a particular situation or material to the teachings of the present invention. Therefore, it is intended that the present invention not be limited to the particular embodiment disclosed, but that the present invention will include all embodiments falling within the scope of the claims.

## Claims

1. A cooling system (60) for cooling at least one heat-generating electronic device (62), the cooling system comprising:
a heat removal device (74) including a surface (114) that is thermally couplable to the at least one heat-generating electronic device, the heat removal device including an inlet area (102; 200) and at least one jet impingement feature (110; 210) fluidly coupled to the inlet area, wherein the at least one jet impingement feature is positioned to direct a primary cooling fluid (C1) toward the surface that is thermally coupled to the at least one heat-generating electronic device.

2. The cooling system of claim 1, wherein the heat removal device includes a heat exchanger (74) having an outlet header (104), the surface that is thermally coupled to the at least one heat-generating electronic device being arranged within the outlet header, wherein the primary cooling fluid and a secondary cooling fluid (C2) are arranged in a heat transfer relationship within the at least one heat exchanger.

3. The cooling system of claim 2 wherein the heat exchanger further comprises:
an inlet header (102), the inlet area being defined by the inlet header; and
a plurality of heat exchange tubes (100) extending between the inlet header and the outlet header, the at least one jet impingement feature being separate from and fluidly coupled to the plurality of heat exchange tubes.

4. The cooling system of claim 2, wherein the heat exchanger further comprises:
an inlet header (102), the inlet area being defined by the inlet header; and
a plurality of heat exchange tubes (100) extending between the inlet header and the outlet header, the at least one jet impingement feature being integral with at least one of the plurality of heat exchange tubes.

5. The cooling system of any of the preceding claims, further comprising a fluid movement device operable to move the secondary cooling fluid through the heat removal device, optionally wherein the fluid movement device is a fan and the secondary cooling fluid is air.

6. The cooling system of any of the preceding claims, wherein the heat removal device further comprises a plurality of heat exchangers, each of the plurality of heat exchangers being located at and thermally coupled to a respective heat-generating electronic device.

7. The cooling system of claim 6, wherein at least some of the plurality of heat exchangers are arranged in series relative to a flow of the primary cooling fluid.

8. The cooling system of claim 6 or 7, wherein at least some of the plurality of heat exchangers are arranged in parallel relative to a flow of the primary cooling fluid.

9. The cooling system of any preceding claim, wherein the primary cooling fluid provided to the inlet area is a two-phase liquid.

10. The cooling system of any of claims 1 to 9, wherein the primary cooling fluid provided to the heat removal device is a single-phase liquid.

11. A method of cooling an assembly including at least one heat-generating electronic device (62) and at least one peripheral heat-generating device, the method comprising:
cooling a secondary cooling fluid (C2) via a primary cooling fluid (C1);
flowing the cooled secondary cooling fluid over the at least one peripheral heat-generating device; and
expelling the primary cooling fluid at a surface of a heat removal device (74) thermally coupled to the at least one heat-generating electronic device via at least one jet impingement feature (110) to cool the at least one heat-generating electronic device.

12. The method of claim 11, wherein the heat removal device is a heat exchanger (74) and cooling the secondary cooling fluid via the primary cooling fluid occurs within a plurality of heat exchanger tubes (100) of the heat exchanger.

13. The method of claim 12, further comprising providing the secondary cooling fluid to the heat exchanger via a fluid movement device.

14. The method of any claims 11-13, further comprising providing the primary cooling fluid to another heat removal device located at and thermally coupled to the at least one heat-generating electronic device, the another heat removal device being arranged downstream from and in series with the heat removal device relative to a flow of the primary cooling fluid.

15. The method of any of claims 11-13, further comprising providing the primary cooling fluid to another heat removal device located at and thermally coupled to the at least one heat-generating electronic device, the another heat removal device being arranged in parallel with the heat removal device relative to a flow of the primary cooling fluid.
